# EUROPEAN PATENT APPLICATION

(11) **EP 4 425 537 A2**
(43) Date of publication of application: **04.09.2024**
(21) Application number: 24159904.2
(22) Date of filing: 27.02.2024
(51) Int. Cl.: H01L 21/48, H01L 23/495

(54) **HYBRID MULTI-DIE QFP-QFN PACKAGE**

(30) Priority: 02.03.2023 US 202363449366 P; 14.02.2024 US 202418441210
(71) Applicant: STMicroelectronics International N.V., 1228 Plan-les-Ouates, Geneva (CH)
(72) Inventor: LOO, Shei Meng, Singapore 730162 (SG); DE JESUS, Edsel Bernaldez, Sengkang 547207 (SG)
(74) Representative: Casalonga

(57) **Abstract**

A hybrid QFN and QFP integrated circuit package includes a leadframe with first second die pads supporting first and second integrated circuits, respectively. The leadframe further includes QFN conductive pads QFP conductive leads. A package housing encapsulates the first and second die pads, the first and second integrated circuits mounted thereto, the QFN conductive pads, and proximal ends of the QFP conductive leads. Distal ends of the QFP conductive leads extend away from side edges of the package housing. Bottom surfaces of the QFN conductive pads are exposed at a bottom surface of the package housing. The QFN conductive pads are located between the first and second die pads.

## Description

### CROSS REFERENCE TO RELATED APPLICATIONS

This application claims priority from United States Provisional Application for Patent No. 63/449,366, filed March 2, 2023, the disclosure of which is incorporated herein by reference.

### TECHNICAL FIELD

The present invention generally relates to semiconductor packaging and, more particularly, to a combined Quad Flat No-Lead (QFN) and Quad Flat Package (QFP) semiconductor package supporting multiple integrated circuit dies.

### BACKGROUND

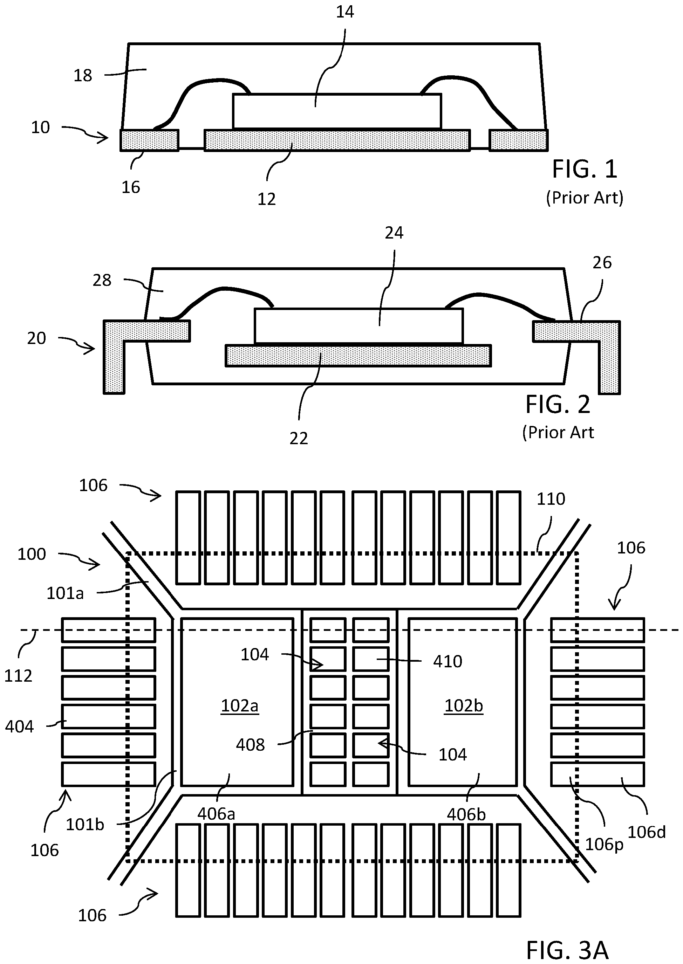

Various kinds of packages are known in the art for semiconductor devices. The known Quad Flat No-Lead (QFN) package type, shown in Figure 1, is based on the use of a leadframe 10 including a die pad 12 supporting an integrated circuit die 14. The exposed device contacts of the package are provided in the form of conductive pads 16 flush with the bottom and side edges of the package housing 18 that are electrically connected to the integrated circuit die 14 through bonding wires. The known Quad Flat Package (QFP) package type, shown in Figure 2, is also based on the use of a leadframe 20 including a die pad 22 supporting an integrated circuit die 24. However, here the exposed device contacts of the package are provided in the form of conductive leads 26 that project from the sides of the package housing 28 that are electrically connected to the integrated circuit die 24 through bonding wires.

It is recognized that some applications require the use of multiple integrated circuit dies within a single package. In such a case, the leadframe is provided with a corresponding number of dies pads and typically with a larger number of device contacts. Increasing the number of die pads can introduce a number of problems such as: difficulty in clamping the leadframe in order to flatten the die pads to ensure a successful bonding of the integrated circuit dies; and inability to provide a sufficient number of device contacts to handle the increased input/output complexity of supporting multiple integrated circuit dies in a single package.

There is accordingly a need in the art to address the foregoing issues. There would be an advantage to have a semiconductor package that supports multiple integrated circuit dies and combines the use of QFN conductive pads and QFP conductive leads to provide for increased input/output complexity.

### SUMMARY

In an embodiment, a hybrid Quad Flat No-Lead (QFN) and Quad Flat Package (QFP) integrated circuit package comprises: a leadframe including a first die pad, a second die pad, a plurality of first QFN conductive pads and a plurality of QFP conductive leads; a first integrated circuit mounted to the first die pad; a second integrated circuit mounted to the second die pad; and a package housing encapsulating the first die pad, the first integrated circuit mounted thereto, the second die pad, the second integrated circuit mounted thereto, the plurality of first QFN conductive pads, and proximal ends of the plurality of QFP conductive leads; wherein distal ends of the plurality of QFP conductive leads extend away from side edges of the package housing; and wherein bottom surfaces of the plurality of first QFN conductive pads are exposed at a bottom surface of the package housing; and wherein said plurality of first QFN conductive pads are located between the first and second die pads.

In an embodiment, a method of manufacturing a hybrid QFN and QFP integrated circuit package comprises: processing a metal plate to provide a proto-leadframe structure that includes a base plate and a plurality of lead structures; forming, in an upper surface of the base plate, a first die pad opening, a second die pad opening, and recesses surrounding pad structures positioned between the first and second die pad openings; mounting a first integrated circuit at the first die pad opening; mounting a second integrated circuit at the second die pad opening; encapsulating the base plate, the first integrated circuit mounted at the first die pad opening, the second integrated circuit mounted at the second die pad opening, and proximal ends of the plurality of lead structures; thinning the base plate from a backside thereof to remove material of the base plate until reaching the recesses surrounding pad structures and producing a plurality of QFN conductive pads; and processing distal ends of the lead structures to produce a plurality of QFP conductive leads.

In an embodiment, a hybrid QFN and QFP leadframe comprises: a base plate and a plurality of lead structures; a first die pad opening formed in an upper surface of the base plate; a second die pad opening formed in an upper surface of the base plate; and recesses formed in an upper surface of the base plate that surround pad structures positioned between the first and second die pad openings. Said first and second die pad openings have a first depth from a front surface of the base plate. Said recesses have a second depth from the front surface of the base plate. Wherein, said second depth is deeper than said first depth.

### BRIEF DESCRIPTION OF THE DRAWINGS

For a better understanding of the embodiments, reference will now be made by way of example only to the accompanying figures in which:
Figure 1 shows a cross-section of a Quad Flat No-Lead (QFN) package;
Figure 2 shows a cross-section of a Quad Flat Package (QFP) package;
Figures 3A, 3B and 3C show plan views of a hybrid QFN-QFP leadframe supporting multiple integrated circuit dies;
Figures 4 and 5 show cross-sections of a hybrid multi-die QFP-QFN package utilizing the leadframe shown in Figures 3A, 3B and 3C; and
Figures 6A-6G show steps in a method for manufacturing the hybrid multi-die QFP-QFN package.

### DETAILED DESCRIPTION

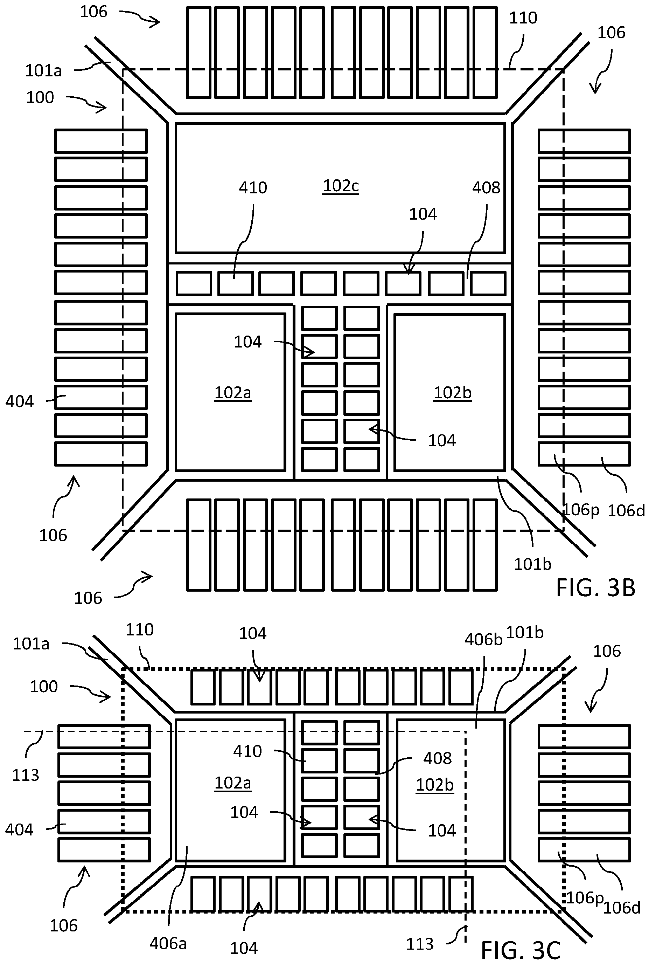

Reference is made to Figures 3A, 3B and 3C which show plan (top) views of a hybrid Quad Flat No-Lead (QFN)-Quad Flat Package (QFP) leadframe 100 supporting multiple integrated circuit dies. The leadframe 100 includes tie bar structures 101a extending from the corners of a central region 101b. The leadframe 100 in Figures 3A and 3C includes two die pads 102a, 102b, a plurality of QFN conductive pads 104 and a plurality of QFP conductive leads 106. The leadframe 100 in Figure 3B includes three die pads 102a, 102b, 102c, a plurality of QFN conductive pads 104 and a plurality of QFP conductive leads 106. Each QFP conductive lead 106 includes a proximal end 106p located within the boundary of the package designated by the dotted perimeter line 110 and a distal end 106d located outside the boundary of the package. Wirebonding of the integrated circuit dies is made to the upper surfaces at the proximal ends 106p of the QFP conductive leads 106. Wirebonding of the integrated circuit dies is further made to the upper surfaces of the QFN conductive pads 104.

It will be noted that in the central region 101b for the leadframes 100 the plurality of QFN conductive pads 104 are positioned between adjacent die pads 102. For example, between die pads 102a and 102b in Figure 3A, and between die pads 102a and 102b, between die pads 102a and 102c and between die pads 102b and 102c in Figure 3B. The embodiments of Figures 3A and 3B do not show the use of QFN conductive pads 104 at the boundary of the package designated by the dotted perimeter line 110. However, it will be understood that such placement of QFN conductive pads 104 at the package boundary, in addition to placement between die pads 102a and 102b in the central region 101b, may be supported as shown, for example, in Figure 3C.

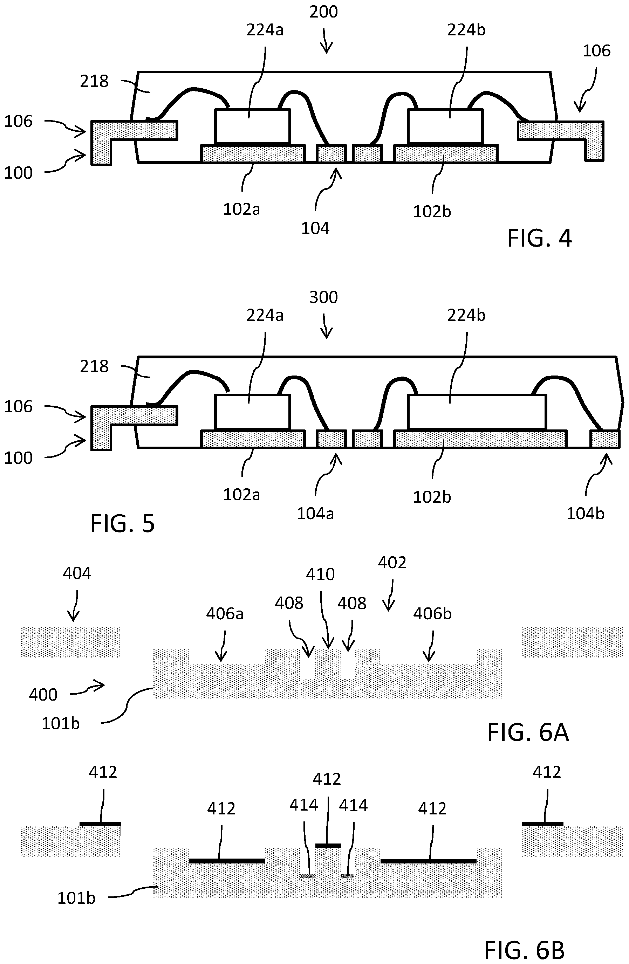

Reference is now made to Figure 4 which shows a cross-section of a hybrid multi-die QFP-QFN package 200. The cross-section of Figure 4 is taken along line 112 in Figure 3A. The leadframe 100 includes a first die pad 102a supporting a first integrated circuit die 224a and a second die pad 102b supporting a second integrated circuit die 224b. The exposed device contacts for the package 200 include QFN conductive pads 104 flush with the bottom of the package housing 218 that are electrically connected to the integrated circuit dies 224a, 224b through bonding wires and QFP conductive leads 106 that project from the sides of the package housing 228 that are electrically connected to the integrated circuit dies 224a, 224b through bonding wires. It will also be noted that the bottom surfaces of the first second die pads 102a and 102b are exposed flush with the bottom of the package housing 218 in support of making electrical and/or thermal contact.

Reference is now made to Figure 5 which shows a cross-section of a hybrid multi-die QFP-QFN package 300. The cross-section of Figure 5 is taken along line 113 in Figure 3C. The leadframe 100 includes a first die pad 102a supporting a first integrated circuit die 224a and a second die pad 102b supporting a second integrated circuit die 224b. The exposed device contacts for the package 200 include QFN conductive pads 104a flush with the bottom of the package housing 218 as well as QFN conductive pads 104b flush with the bottom and side edges of the package housing 218; wherein the pads 104a, 104b are electrically connected to the integrated circuit dies 224a, 224b through bonding wires. The exposed device contacts for the package 200 further include QFP conductive leads 106 that project from the sides of the package housing 228; wherein the leads 106 are electrically connected to the integrated circuit dies 224a, 224b through bonding wires. It will also be noted that the bottom surfaces of the first second die pads 102a and 102b are exposed flush with the bottom of the package housing 218 in support of making electrical and/or thermal contact.

Figures 6A-6G show steps in a method for manufacturing the hybrid multi-die QFP-QFN package.

Figure 6A - a metal plate, for example made of copper, is processed using etching, stamping, patterning, etc., techniques as known in the art to provide a proto-leadframe structure 400 that includes a base plate 402 and a plurality of lead structures 404. The stamping or patterning process may be is used to define the peripheral shapes of the base plate 402 and lead structures 404. An etching process is used to form, in the upper surface of the base plate 402, a first die pad opening 406a, a second die pad opening 406b, and recesses 408 surrounding pad structures 410. It will be noted that the stamping process may further introduce a vertical offset of the lead structures 404 relative to the base plate 402. The top views of the leadframe 100 shown in Figures 3A-3C are illustrative of the leadframe configuration at this step of the process.

Figure 6B - a solder layer 412 is applied at the bottom of the first die pad opening 406a, at the bottom of the second die pad opening 406b, to the upper surface of the pad structures 410, and to the upper surface of lead structures 404 at the ends thereof which are proximate to the base plate 402. An insulating later 414 is applied at the bottom of the recesses 408.

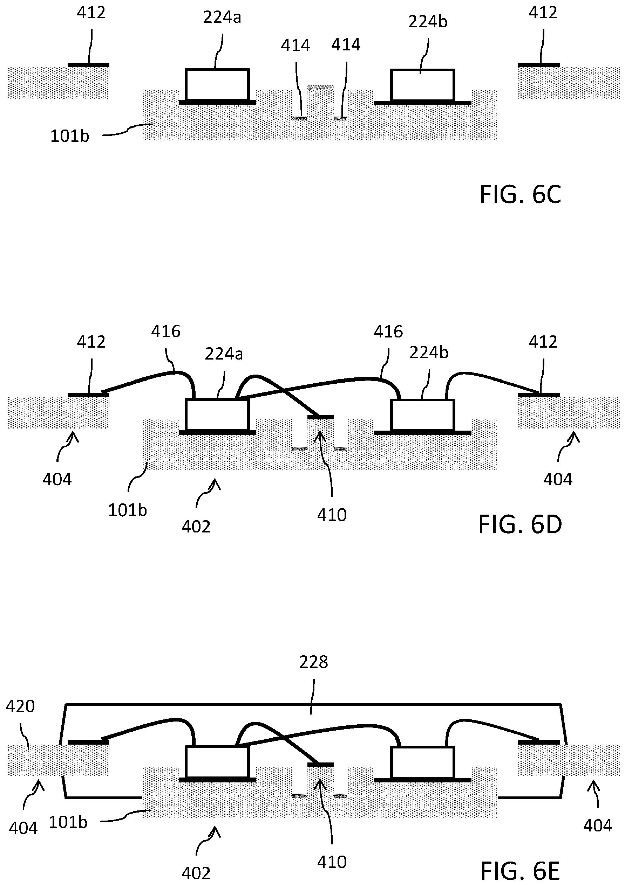

Figure 6C - a die attach process is then performed to mount the first and second integrated circuit dies 224a, 224b to the base plate 402 within the first die pad opening 406a and the second die pad opening 406b, respectively.

Figure 6D - wire bonding is then performed to electrically connect, via bonding wires 416, pads of the first and second integrated circuit dies 224a, 224b to each other, pads of the first and second integrated circuit dies 224a, 224b to the solder layer 412 at the proximal ends of the lead structures 404 and pads of the first and second integrated circuit dies 224a, 224b to the solder layer 412 at the upper surface of the pad structures 410. It will be noted that the bonding wires 416 between the first and second integrated circuit dies 224a, 224b pass over one or more of the pad structures 410.

Figure 6E - the proto-leadframe structure 400 with the mounted and wire bonded first and second integrated circuit dies 224a, 224b is then placed within a molding cavity and an encapsulation material (such as a curable resin) is injected in the molding cavity to produce the package housing 228. This transfer molding process is well known in the art. The distal ends 420 of the lead structures 404 are clamped by the molding apparatus and thus are not encapsulated so that they will extend from the outer peripheral sides of the package housing 228. The base plate 402 of the proto-leadframe structure 400 is only partially encapsulated within the package housing 228; wherein a bottom portion of the base plate 402 is exposed from the package housing 228.

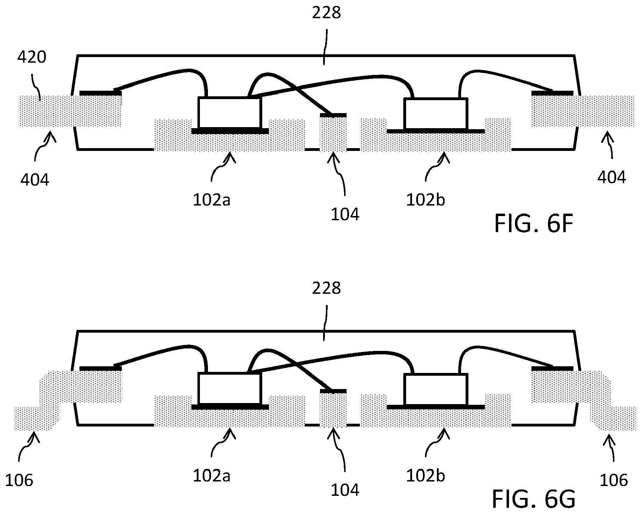

Figure 6F - an etching and/or grinding process is then applied to the backside of the base plate 402 of the proto-leadframe structure 400 (and perhaps also, if needed, to the bottom portion of the package housing 228) in order to reduce the thickness of the base plate 402. This backside etch/grind process performed on the base plate 402 continues removing material of the base plate 402 until reaching the encapsulant material filled recesses 408 surrounding pad structures 410. In particular, the backside etch/grind process is continued until the insulating later 414 present at the bottom of the recesses 408 is reached and removed. At this point, the pad structures 410 become individually isolated to form the plurality of QFN conductive pads 104 and portions of the base plate 403 become individually isolated to form the first and second die pad 102a and 102b.

Figure 6G - a trimming and forming process is then performed at the distal ends 420 of the lead structures 404 to individually isolate and shape the lead structures 404 to form the plurality of QFP conductive leads 106. At this stage, the exposed ends of the tie bars 101a are also severed.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A hybrid Quad Flat No-Lead (QFN) and Quad Flat Package (QFP) integrated circuit package, comprising:
a leadframe including a first die pad, a second die pad, a plurality of first QFN conductive pads and a plurality of QFP conductive leads;
a first integrated circuit mounted to the first die pad;
a second integrated circuit mounted to the second die pad; and
a package housing encapsulating the first die pad, the first integrated circuit mounted thereto, the second die pad, the second integrated circuit mounted thereto, the plurality of first QFN conductive pads, and proximal ends of the plurality of QFP conductive leads;
wherein distal ends of the plurality of QFP conductive leads extend away from side edges of the package housing; and
wherein bottom surfaces of the plurality of first QFN conductive pads are exposed at a bottom surface of the package housing; and
wherein said plurality of first QFN conductive pads are located between the first and second die pads.

2. The hybrid QFN and QFP integrated circuit package of claim 1, wherein said leadframe further includes a plurality of second QFN conductive pads, wherein the package housing further encapsulates the plurality of second QFN conductive pads, and wherein said plurality of second QFN conductive pads are exposed at the bottom surface and at least one side edge of the package housing.

3. The hybrid QFN and QFP integrated circuit package of claim 1, wherein said leadframe further includes a third die pad, further including a third integrated circuit mounted to the third die pad, wherein the package housing further encapsulates the third die pad and the third integrated circuit mounted thereto, and wherein said plurality of first QFN conductive pads are further located between the first and third die pads and between the second and third die pads.

4. The hybrid QFN and QFP integrated circuit package of claim 1, further comprising wirebonds between each of the first and second integrated circuits and proximal ends of the plurality of QFP conductive leads.

5. The hybrid QFN and QFP integrated circuit package of claim 4, further comprising a solder layer at upper surfaces of the plurality of first QFP conductive leads at the proximal ends thereof; wherein said wirebonds are connected to said solder layer.

6. The hybrid QFN and QFP integrated circuit package of claim 1, further comprising wirebonds between each of the first and second integrated circuits and upper surfaces of the plurality of first QFN conductive pads.

7. The hybrid QFN and QFP integrated circuit package of claim 6, further comprising a solder layer at upper surfaces of the plurality of first QFN conductive pads; wherein said wirebonds are connected to said solder layer.

8. The hybrid QFN and QFP integrated circuit package of claim 1, further comprising wirebonds between the first and second integrated circuits that pass over on or more of the plurality of first QFN conductive pads located between the first and second die pads.

9. The hybrid QFN and QFP integrated circuit package of claim 1, further comprising solder layers at surfaces of the first and second die pads; wherein said first and second integrated circuits are mounted to the solder layers.

10. A method of manufacturing a hybrid Quad Flat No-Lead (QFN) and Quad Flat Package (QFP) integrated circuit package, comprising:
processing a metal plate to provide a proto-leadframe structure that includes a base plate and a plurality of lead structures;
forming, in an upper surface of the base plate, a first die pad opening, a second die pad opening, and recesses surrounding pad structures positioned between the first and second die pad openings;
mounting a first integrated circuit at the first die pad opening;
mounting a second integrated circuit at the second die pad opening;
encapsulating the base plate, the first integrated circuit mounted at the first die pad opening, the second integrated circuit mounted at the second die pad opening, and proximal ends of the plurality of lead structures;
thinning the base plate from a backside thereof to remove material of the base plate until reaching the recesses surrounding pad structures and producing a plurality of QFN conductive pads; and
processing distal ends of the lead structures to produce a plurality of QFP conductive leads.

11. The method of claim 10, further comprising:
applying a solder layer to upper surfaces of the plurality of lead structures at the proximal ends thereof; and
wirebonding one or more of the first and second integrated circuits to the solder layer at the proximal ends of the plurality of lead structures.

12. The method of claim 10, further comprising:
applying a solder layer to upper surfaces of the pad structures; and
wirebonding one or more of the first and second integrated circuits to the solder layer at the upper surfaces of the pad structures.

13. The method of claim 10, further comprising:
applying a solder layer to bottoms of the first and second die pad openings; and
wherein mounting the first and second integrated circuits comprises mounting to the solder layer.

14. The method of claim 10, further comprising, after forming the recesses surrounding pad structures and before encapsulating the base plate, applying an insulating layer to bottoms of the recesses surrounding pad structures.

15. The method of claim 14, wherein thinning the base plate is continued until the insulating layer at the bottoms of the recesses surrounding pad structures is reached.

16. A hybrid Quad Flat No-Lead (QFN) and Quad Flat Package (QFP) leadframe, comprising:
a base plate and a plurality of lead structures;
a first die pad opening formed in an upper surface of the base plate;
a second die pad opening formed in an upper surface of the base plate; and
recesses formed in an upper surface of the base plate that surround pad structures positioned between the first and second die pad openings.

17. The hybrid QFN and QFP leadframe of claim 16, wherein said first and second die pad openings have a first depth from a front surface of the base plate, and wherein said recesses have a second depth from the front surface of the base plate, said second depth being deeper than said first depth.

18. The hybrid QFN and QFP leadframe of claim 16, further comprising a solder layer at upper surfaces of the plurality of lead structures at proximal ends thereof.

19. The hybrid QFN and QFP leadframe of claim 16, further comprising a solder layer at upper surfaces of the pad structures.

20. The hybrid QFN and QFP leadframe of claim 16, further comprising a solder layer at bottoms of the first and second die pad openings.

21. The hybrid QFN and QFP leadframe of claim 16, further comprising an insulating layer at bottoms of the recesses surrounding pad structures.

22. The hybrid QFN and QFP leadframe of claim 16, wherein said plurality of lead structures include QFP leads and QFN pads.

23. The hybrid QFN and QFP leadframe of claim 16, wherein said pad structures are configured to form QFN pads.
